# EUROPEAN PATENT APPLICATION

(11) **EP 4 575 596 A1**
(43) Date of publication of application: **25.06.2025**
(21) Application number: 23218908.4
(22) Date of filing: 20.12.2023
(51) Int. Cl.: G02B 6/12, G02B 6/122, G02B 6/13

(54) **PHOTONIC CIRCUIT LAYOUT**

(71) Applicant: Akhetonics GmbH, 10823 Berlin (DE)
(72) Inventor: Kissner, Michael, 79117 Freiburg (DE); Del Bino, Leonardo, 80997 Munich (DE)
(74) Representative: Legl, Stefan

(57) **Abstract**

The present disclosure relates to a computer-implemented method for constructing a photonic circuit layout. The method includes generating a photonic circuit layout by defining a stack of a plurality of architecture layers and/or defining one or more lanes and/or defining a plurality of routes.

## Description

### FIELD

Embodiments of the present disclosure relate to a computer-implemented method for constructing a photonic circuit layout, a computer program for carrying out the method, a computer-readable storage medium comprising instructions for carrying out the method, a data processing system for constructing a photonic circuit layout, and a photonic circuit layout. More particularly, the present disclosure relates to an all-optical very large scale integration (VLSI) using a standard cell approach.

### BACKGROUND

Integrated circuits (ICs) contain components that form a functional circuit and are nowadays used in almost all electronic equipment, such as smartphones and computers. In conventional electronic ICs, electrons pass through electrical components such as resistors, inductors, transistors, and capacitors. Electronic ICs offer benefits such as mass production capability and reliability. Recently, photonic ICs have been developed to replace or supplement conventional electronic ICs. In photonic ICs, photons pass through optical components such as waveguides, lasers, polarizers, and phase shifters. Compared to conventional electronic ICs, photonic ICs offer benefits such as miniaturization, higher speed, low thermal effects, and large integration capacity.

There are major differences between electronic ICs and photonic ICs. For example, electric wires can do sharp 90° bends - optical waveguides must have smooth bends. There are also different size scales and space constraints. Therefore, IC design approaches used for conventional electronic ICs cannot be used for photonic ICs.

### SUMMARY

In light of the above, a computer-implemented method for constructing a photonic circuit layout, a computer program for carrying out the method, a computer-readable storage medium comprising instructions for carrying out the method, a data processing system for constructing a photonic circuit layout, and a photonic circuit layout are provided.

It is an object of the present disclosure to efficiently generate photonic circuit layouts. It is another object of the present disclosure to provide photonic circuits with increased operational efficiency and/or compact design.

The objects are solved by the features of the independent claims. Preferred embodiments are defined in the dependent claims.

According to an independent aspect of the present disclosure, a computer-implemented method for constructing a photonic circuit layout is provided. The method includes generating a photonic circuit layout by defining a stack of a plurality of architecture layers and/or defining one or more lanes and/or defining a plurality of routes.

According to some embodiments, which can be combined with other embodiments described herein, the plurality of architecture layers include at least one first architecture layer dedicated to routing and/or at least one second architecture layer dedicated to photonic cells, such as photonic standard cells.

According to some embodiments, which can be combined with other embodiments described herein, each lane of the one or more lanes includes at least one waveguide bypassing at least one architecture layer of the plurality of architecture layers.

According to some embodiments, which can be combined with other embodiments described herein, each route of the plurality of routes defines a waveguide path, preferably within the at least one first architecture layer dedicated to routing.

According to some embodiments, which can be combined with other embodiments described herein, generating the photonic circuit layout further includes arranging a circuit input and a circuit output at a same side of the stack of the plurality of architecture layers.

According to some embodiments, which can be combined with other embodiments described herein, generating the photonic circuit layout further includes arranging a circuit input and a circuit output at opposite sides of the stack of the plurality of architecture layers.

According to some embodiments, which can be combined with other embodiments described herein, the photonic circuit layout is generated using a standard cell representation related to (or defining) a plurality of photonic standard cells.

According to some embodiments, which can be combined with other embodiments described herein, the standard cell representation includes, or is, an optical standard cell netlist.

According to some embodiments, which can be combined with other embodiments described herein, the plurality of photonic standard cells are selected from the group including (or consisting of) data processing cells, memory cells, light-related cells, in particular optical amplification cells and/or laser cells, and delay cells.

According to some embodiments, which can be combined with other embodiments described herein, the plurality of photonic standard cells include (or consist of) at least one data processing cell, at least one memory cell and at least one light-related cells.

According to some embodiments, which can be combined with other embodiments described herein, the plurality of photonic standard cells include at least 10 data processing cells; and/or at most 10000 data processing cells, at most 10000 memory cells and at most 1000 light-related cells.

According to some embodiments, which can be combined with other embodiments described herein, the plurality of photonic standard cells include (or consist of) at most 10000 data processing cells, at most 10000 memory cells and at most 1000 light-related cells.

According to some embodiments, which can be combined with other embodiments described herein, the plurality of photonic standard cells include at least 10 and/or at most 10000 data processing cells, more preferably at least 50 and/or at most 5000 data processing cells, most preferably at least 100 and/or at most 1000 data processing cells. Additionally, or alternatively, the plurality of photonic standard cells include at least 10 and/or at most 1000 memory cells, more preferably at least 50 and/or at most 5000 memory cells, most preferably at least 100 and/or at most 1000 memory cells. Additionally, or alternatively, the plurality of photonic standard cells include at least 10 and/or at most 1000 light-related cells, more preferably at least 50 and/or at most 500 light-related cells, most preferably at least 100 and/or at most 100 light-related cells.

According to some embodiments, which can be combined with other embodiments described herein, the plurality of architecture layers are stacked in feed-forward.

According to some embodiments, which can be combined with other embodiments described herein, a first architecture layer dedicated to routing is arranged between two second architecture layers dedicated to photonic standard cells to provide an interface between the two second architecture layers.

According to some embodiments, which can be combined with other embodiments described herein, the one or more lanes include at least one first lane, wherein the at least one first lane is a feed-forward lane.

According to some embodiments, which can be combined with other embodiments described herein, the one or more lanes include at least one second lane, wherein the at least one second lane is a feed-backward lane.

According to some embodiments, which can be combined with other embodiments described herein, at least two routes of the plurality of routes within the at least one first architecture layer dedicated to routing cross.

According to some embodiments, which can be combined with other embodiments described herein, at least one route of the plurality of routes within the at least one first architecture layer dedicated to routing has a non-sharp bend.

Preferably, the non-sharp bend has a rounded shape (compared to a sharp bend which has a pointed edge, i.e., is not rounded).

According to some embodiments, which can be combined with other embodiments described herein, the plurality of routes are arranged based on Manhattan routing.

Preferably, the at least one first architecture layer has a plurality of sub-layers, wherein the plurality of routes are arranged based on Manhattan routing in each sub-layer of the plurality of sub-layers.

According to some embodiments, which can be combined with other embodiments described herein, the method further includes optimizing the generated photonic circuit layout by re-defining the plurality of architecture layers and/or the one or more lanes and/or the plurality of routes.

Preferably, optimizing the generated photonic circuit layout is performed based on minimizing optical power.

Additionally, or alternatively, optimizing the generated photonic circuit layout is performed based on minimizing a number of optical amplifiers.

Additionally, or alternatively, optimizing the generated photonic circuit layout is performed based on minimizing a maximal routing distance.

Additionally, or alternatively, optimizing the generated photonic circuit layout is performed based on maximizing an extinction ratio.

Additionally, or alternatively, optimizing the generated photonic circuit layout is performed based on minimizing a floor space.

According to another independent aspect of the present disclosure, a computer program is provided. The computer program has instructions which, when the program is executed by a computer, cause the computer to carry out the method for constructing a photonic circuit layout according to the embodiments described in this document.

According to another independent aspect of the present disclosure, a computer-readable storage medium is provided. The computer-readable storage medium has instructions which, when the program is executed by a computer, cause the computer to carry out the method for constructing a photonic circuit layout according to the embodiments described in this document.

Preferably, the computer-readable storage medium is a non-transitory computer-readable storage (or memory) medium. The term "non-transitory computer-readable storage (or memory) medium" includes, but is not limited to, magnetic or optical media, e.g., disks, hard drives, or DVDs/CD-ROMs, volatile or non-volatile media such as RAM (e.g., SDRAM, DDR, RDRAM, SRAM, etc.), ROM, etc. The non-transitory computer-readable storage (or memory) medium may include other types of non-transitory memory as well or combinations thereof.

According to another independent aspect of the present disclosure, a data processing system for constructing a photonic circuit layout is provided. The data processing system includes one or more processors configured to generate a photonic circuit layout by defining a stack of a plurality of architecture layers and/or defining one or more lanes and/or defining a plurality of routes.

According to some embodiments, which can be combined with other embodiments described herein, the photonic circuit layout is generated using a standard cell representation defining a plurality of photonic standard cells.

According to some embodiments, which can be combined with other embodiments described herein, the plurality of architecture layers include at least one first architecture layer dedicated to routing and/or at least one second architecture layer dedicated to photonic cells, such as photonic standard cells.

According to some embodiments, which can be combined with other embodiments described herein, each lane of the one or more lanes includes at least one waveguide bypassing at least one architecture layer of the plurality of architecture layers.

According to some embodiments, which can be combined with other embodiments described herein, each route of the plurality of routes defines a waveguide path, preferably within the at least one first architecture layer dedicated to routing.

According to some embodiments, which can be combined with other embodiments described herein, the one or more processors of the data processing system are configured to perform the computer-implemented method for constructing a photonic circuit layout according to the embodiments described in this document.

According to another independent aspect of the present disclosure, a photonic circuit layout is provided. The photonic circuit layout includes a stack of a plurality of architecture layers and/or one or more lanes and/or a plurality of routes.

According to some embodiments, which can be combined with other embodiments described herein, the plurality of architecture layers include at least one first architecture layer dedicated to routing and/or at least one second architecture layer dedicated to photonic cells, such as photonic standard cells.

According to some embodiments, which can be combined with other embodiments described herein, each lane of the one or more lanes includes at least one waveguide bypassing at least one architecture layer of the plurality of architecture layers.

According to some embodiments, which can be combined with other embodiments described herein, each route of the plurality of routes defines a waveguide path, preferably within the at least one first architecture layer dedicated to routing.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
- FIG. 1: shows a photonic circuit layout according to embodiments described herein;
- FIG. 2: shows a flow chart of a computer-implemented method for constructing a photonic circuit layout according to embodiments described herein;
- FIG. 3: shows a real chip implementation of the photonic circuit layout according to embodiments described herein;
- FIG. 4: shows a layout of a photonic standard cell according to embodiments described herein;
- FIG. 5: shows an exemplary standard cell including NAND and XOR logic gates according to embodiments described herein;
- FIG. 6: shows a photonic standard cell netlist and a physical layout resulting from the photonic standard cell netlist according to embodiments described herein;
- FIG. 7A: shows routing in an architecture layer according to embodiments described herein;
- FIG. 7B: shows routing examples according to embodiments described herein;
- FIG. 7C: shows routing examples according to further embodiments described herein;
- FIG. 8: shows a layout of a photonic circuit layout according to embodiments described herein;
- FIG. 9: shows a layout of a photonic circuit layout according to further embodiments described herein; and
- FIG. 10: shows a partial photonic circuit layout according to embodiments described herein.

### DETAILED DESCRIPTION OF EMBODIMENTS

Reference will now be made in detail to the various embodiments of the disclosure, one or more examples of which are illustrated in the figures. Within the following description of the drawings, the same reference numbers refer to same components. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

This document includes references to "one embodiment" or "an embodiment". The appearances of the phrases "in one embodiment" or "in an embodiment" do not necessarily refer to the same embodiment. Particular features, structures, or characteristics may be combined in any suitable manner consistent with this disclosure.

The term "comprising" is open-ended. As used in the appended claims, this term does not foreclose additional structure or steps.

Various units, circuits, or other components may be described or claimed as "configured to" perform a task or tasks. In such contexts, "configured to" is used to connote structure by indicating that the units/circuits/components include structure (e.g., circuitry) that performs those task or tasks during operation. As such, the unit/circuit/component can be said to be configured to perform the task even when the specified unit/circuit/component is not currently operational (e.g., is not on). The units/circuits/components used with the "configured to" language include hardware for example, circuits, memory storing program instructions executable to implement the operation, etc. Additionally, "configured to" can include generic structure (e.g., generic circuitry) that is manipulated by software and/or firmware (e.g., an FPGA or a general-purpose processor executing software) to operate in manner that is capable of performing the task(s) at issue.

As used herein, the terms "first", "second", etc. are used as labels for nouns that they precede, and do not imply any type of ordering (e.g., spatial, temporal, logical, etc.).

As used herein, the term "based on" is used to describe one or more factors that affect a determination. This term does not foreclose additional factors that may affect a determination. That is, a determination may be solely based on those factors or based, at least in part, on those factors. Consider the phrase "determine A based on B." While in this case, B is a factor that affects the determination of A, such a phrase does not foreclose the determination of A from also being based on C. In other instances, A may be determined based solely on B.

As used herein, the term "over", e.g. one layer being over the other, is used to define an order of layers, wherein a starting point is a base such as a substrate. This is irrespective of whether the device is depicted upside down or not.

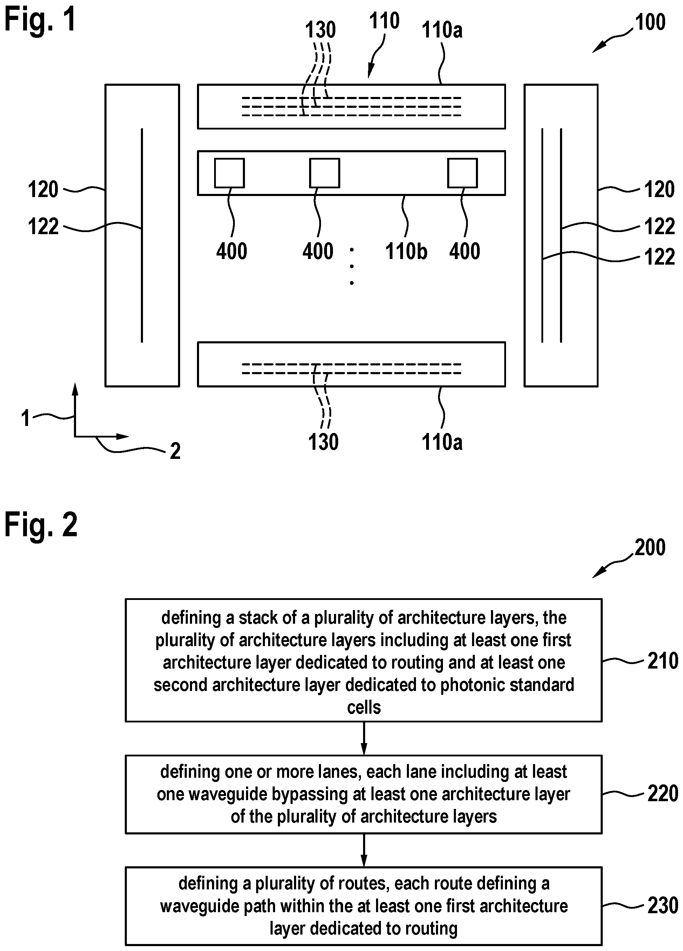

FIG. 1 shows a photonic circuit layout 100 constructed according to embodiments described herein. FIG. 2 shows a flow chart of a computer-implemented method 200 for constructing the photonic circuit layout 100.

In photonic ICs, photons pass through optical components such as waveguides, lasers, polarizers, and phase shifters. Compared to conventional electronic ICs, photonic ICs offer benefits such as miniaturization, higher speed, low thermal effects, and large integration capacity. There are major differences between electronic ICs and photonic ICs. For example, electric wires can do sharp 90° bends - optical waveguides must have smooth bends. There are also different size scales and space constraints. Therefore, IC design approaches used for conventional electronic ICs cannot be used for photonic ICs.

Photonic ICs can be designed manually by a designer. However, the manual design of photonic ICs is time-consuming and subject to errors, as the designer must know the physical structure of the photonic components in detail. This is all the more relevant the larger and more complicated the photonic circuits are.

The embodiments of the present disclosure overcome the above drawbacks by constructing a photonic circuit layout 100 using:
(i) a plurality of architecture layers 110 including at least one first architecture layer 110a dedicated to routing and at least one second architecture layer 110b dedicated to photonic standard cells 400 (block 210 in FIG. 2),
(ii) one or more lanes 120, each lane of the one or more lanes 120 including at least one waveguide 122 bypassing at least one architecture layer of the plurality of architecture layers 110 (block 220 in FIG. 2), and
(iii) a plurality of routes 130, each route of the plurality of routes 130 defining a waveguide path within the at least one first architecture layer 110a dedicated to routing (block 230 in FIG. 2).

Using these architecture layers, lanes and routes to construct the photonic circuit layout allows to efficiently construct photonic circuits with increased operational efficiency and compact design. The constructed photonic circuit layouts can be implemented to fabricate the associated photonic circuit, such as via fabrication tools.

It is to be understood that the order of method steps for constructing the photonic circuit layout 100 is not limited to the order of method steps shown in FIG. 2 and can be rearranged.

The term "routing" as used throughout the present disclosure refers to a light path provided by waveguides used to connect, for example, photonic standard cells, inputs, outputs, pins, and the like.

The term "photonic standard cell" as used throughout the present disclosure refers to photonic integrated circuits. In particular, a photonic standard cell consists of optical components that provide a logic function (e.g., AND, OR, XOR, XNOR) or a storage function. The term "photonic standard cell" is used in analogy to the standard cells used in semiconductor design, where a standard cell is a group of transistor and interconnect structures that fulfill a logical function.

In the non-limiting example of FIG. 1, the plurality of architecture layers 110 are stacked along a first direction 1 which is a vertical direction, and the plurality of routes 130 extend in a second direction 2 which is a horizontal direction. However, the present disclosure is not limited thereto.

A number of architecture layers 110, a number of lanes 120, and a number of routes 130 is not limited to the numbers shown in FIG. 1 and may vary depending on the type, application, size etc. of the photonic circuit.

The plurality of architecture layers (or rows) 110 include at least one first architecture layer 110a dedicated to routing, i.e., the at least one first architecture layer 110a includes the plurality of routes 130. Each route of the plurality of routes 130 defines a waveguide path within the at least one first architecture layer 110a. In other words, each route of the plurality of routes 130 corresponds to a respective waveguide.

The plurality of architecture layers 110 further include at least one second architecture layer 110b dedicated to photonic cells 400. Each photonic cell 400 includes, or consists of, one or more optical components such as waveguides, lasers, polarizers, phase shifters, all-optical switches, ring resonators and the like. In some embodiments, each photonic cell 400 is a photonic standard cell described later.

Each lane of the one or more lanes 120 includes at least one waveguide 122 bypassing at least one architecture layer of the plurality of architecture layers 110. The one or more lanes 120 may include at least one feed-forward lane and/or at least one feed-backward lane.

The architecture layers, lanes, and routes enable the photonic circuit layout 100 to be constructed taking into account the characteristics and constraints of photonic ICs that may not be present or may be different from characteristics and constraints of electronic ICs. Exemplary processes and methods for constructing the architecture layers, lanes, and routes are described later.

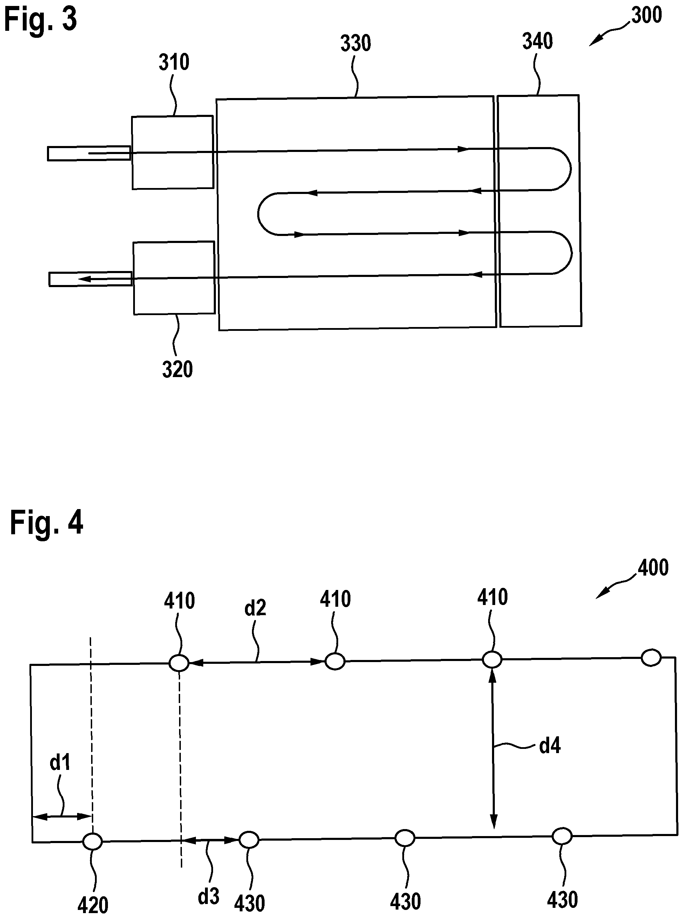

The real or physical layout of the photonic chip can differ from the layout shown in FIG. 1, as, for example, amplification and laser may be in different chips. FIG. 3 shows an exemplary real chip implementation 300 of the photonic circuit layout 100 including an input fiber array 310, an output fiber array 320, a first block 330 (e.g. logic, routing and memory), and a second block 340 (e.g. amplification and restoration). Nevertheless, the real or physical layout of the photonic chip includes (or is based on) the plurality of architecture layers, the one or more lanes, and the plurality of routes of the embodiments of the present disclosure.

The photonic circuit layout 100 can be constructed using a photonic circuit construction system. The photonic circuit construction system may include one or more processors, one or more memories, a user interface and the like to execute the method 200. The generated photonic circuit layout 100 can be stored in a memory of the photonic circuit construction system and/or transmitted to a fabrication tool to control fabrication of the associated photonic circuit.

The photonic circuit layout 100 is constructed using photonic standard cells 400. FIG. 4 shows a layout of an exemplary photonic standard cell 400 according to embodiments described herein.

A photonic standard cell 400 may include, or consist of, one or more optical components such as waveguides, lasers, polarizers, phase shifters, all-optical switches, ring resonators, gratings, reflectors, filters, couplers and the like. However, the present disclosure is not limited thereto, and other and/or additional types of optical components can be used in embodiments of the present disclosure.

Each photonic standard cell 400 is configured to perform one or more functions by means of its optical components. For example, the photonic standard cell 400 can be a data processing cell, a memory cell, a light-related cell (e.g., an optical amplification cell and/or a laser cell), a delay cell, or a combination thereof. However, the present disclosure is not limited thereto, and other and/or additional types of photonic standard cells can be used in embodiments of the present disclosure.

In the example of FIG. 4, the photonic standard cell 400 includes a plurality of input pins 410, an optical power input 420, and a plurality of output pins 430. The photonic standard cell 400 may be constructed based on one or more constraints, such as a padding or minimal distance d1 between an edge of the photonic standard cell 400 and the optical power input 420, a fixed spacing d2 between adjacent input pins 410, a spacing or lateral shift d3 between an input pin 410 and an output pin 430 (e.g., half width of the spacing d2), and/or a fixed height d4. However, the present disclosure is not limited thereto, and other and/or additional constraint can be used to define each photonic standard cell.

In some embodiments, the photonic standard cells used in the construction of the photonic circuit layout 100 may be provided in a standard cell library. The standard cell library can be stored in a memory of the photonic circuit construction system or in an external unit that communicates with the photonic circuit construction system.

In some embodiments, the standard cell library includes a list of photonic standard cells and optionally further information.

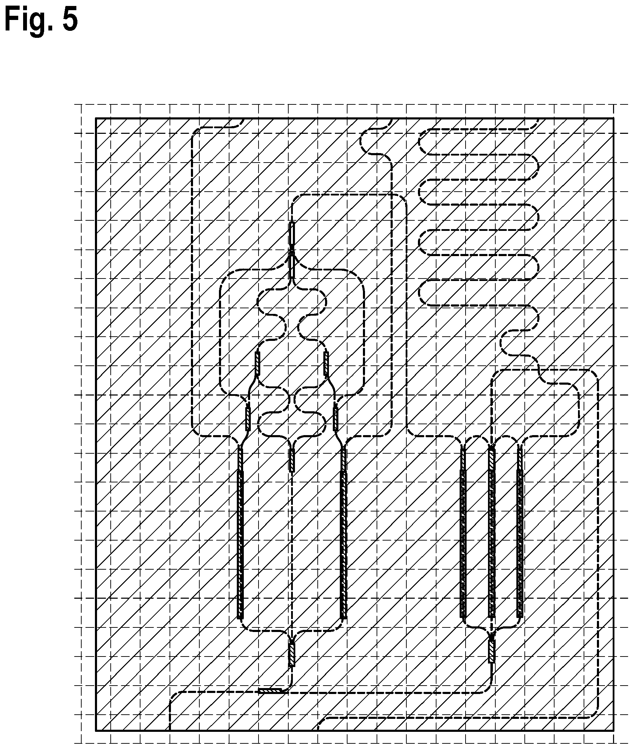

The list of photonic standard cells can include, but is not limited to, data processing cells (e.g., individual logic gates (NAND, NOR) etc.), combined logic gates (e.g., 2xNAND, NAND+NOR etc.), signal processing cells (e.g., serialization, deserialization, analog-digital converter, digital-analog converter etc.), memory cells (e.g., read-only cells, flip-flops etc.), light-related cells (e.g., amplifiers, attenuators, lasers, clocking cells etc.), delay cells (e.g., delay lines, fan-out cells, fan-in cells etc.), and combinations thereof. FIG. 5 shows an exemplary photonic standard cell 500 including NAND and XOR logic gates.

The further information contained in the standard cell library can include, but is not limited to, information about functionalities, sizes in standard units, pin layouts, pin locations, parameters for modifying a behavior of standard cells (e.g., changing a length of delay lines, changing a power of amplifiers etc.), physical models for simulation, optical specifications (e.g., power, phase, wavelength etc.), and/or electrical specifications (e.g., voltage, current etc.).

The photonic circuit layout 100 can be generated using a standard cell representation. The standard cell representation can be provided in the form of a photonic standard cell netlist but is not limited thereto. The photonic standard cell netlist is a graph representation of all photonic standard cells (e.g. the photonic standard cells of the standard cell library) that describes connection relations, e.g., which pins are connected to which. However, the photonic standard cell netlist does not yet contain any information on the physical placement and routing, only on the logical connections. The term "netlist" is used in analogy to the netlists used in semiconductor design, where a netlist is a nodal description of transistors, of their connections to each other, and of their terminals (ports) to the external environment.

The standard cell representation can be stored in a memory of the photonic circuit construction system or in an external unit that communicates with the photonic circuit construction system.

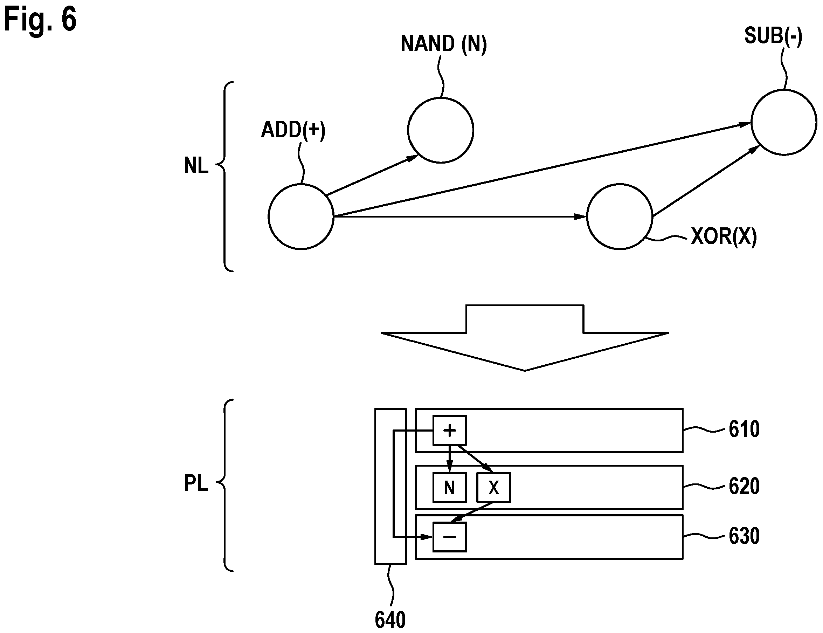

FIG. 6 shows a photonic standard cell netlist NL and a physical layout PL resulting from the photonic standard cell netlist NL.

The photonic standard cell netlist NL defines a connection between a first photonic standard cell ADD (+) and a second photonic standard cell NAND (N), a connection between the first photonic standard cell ADD (+) and a third photonic standard cell SUB (-), a connection between the first photonic standard cell ADD (+) and a fourth photonic standard cell XOR (X), and a connection between the fourth photonic standard cell XOR (X) and the third photonic standard cell SUB (+).

The photonic standard cell netlist NL translates to the physical layout PL having a first architecture layer 610 providing the first photonic standard cell ADD (+), a second architecture layer 620 providing the second photonic standard cell NAND (N) and the fourth photonic standard cell XOR (X), and a third architecture layer 630 providing the third photonic standard cell SUB (-). The physical layout PL further includes a lane 640 connecting the first architecture layer 610 providing the first photonic standard cell ADD (+) and the third architecture layer 630 providing the third photonic standard cell SUB (-) while bypassing the second architecture layer 620.

Exemplary processes and methods used by the photonic circuit construction system to construct the architecture layers, lanes, and routes, for example by using the photonic standard cell netlist and the standard cell library, are described below.

### Architecture Layers

The architecture layers are stacked and include two different types: architecture layers dedicated to routing and architecture layers dedicated to photonic standard cells. In some embodiments, the architecture layers can be ordered in feed-forward, but the present disclosure is not limited thereto.

Different types of photonic standard cells can be mixed in one architecture layer (for example, delays and amplifiers). In some embodiments, architecture layers can be dedicated to specifically hold one class of photonic standard cells to reduce design complexity.

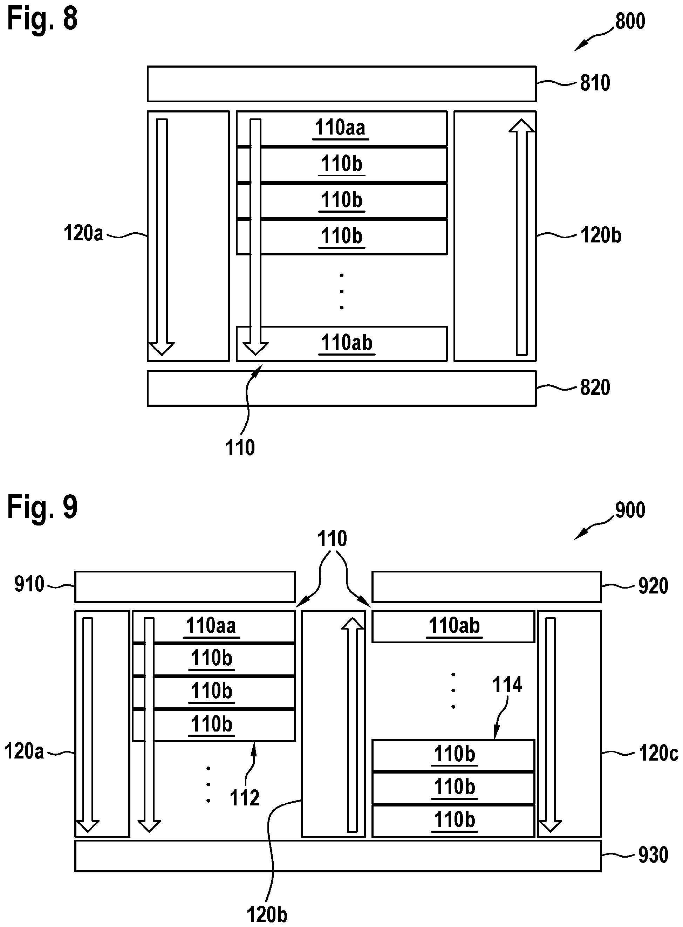

In some embodiments, an architecture layer dedicated to routing can be placed between two architecture layers dedicated to photonic standard cells. This is beneficial if the pins of the photonic standard cells of one architecture layer do not match the pins of the photonic standard cells of the other architecture layer. If all photonic standard cells of two consecutive architecture layers have matching pins, the architecture layers dedicated to routing can be omitted (e.g., FIG. 8).

To determine which photonic standard cell belongs in which architecture layer, a comprehensive "breadth-first" search can be performed, starting with the inputs. The depth of each node (i.e., the jumps from the input) results in the layer hierarchy. If not all photonic standard cells of a certain depth fit into an architecture layer, several layers can be used to divide the photonic standard cell(s).

Exemplary algorithms suitable for configuring the architecture layers include, but are not limited to, an algorithm based on stochastic placement (e.g., similar to simulated annealing-based algorithms), a partitioning-based global placement algorithm, an analytical global placement algorithm (e.g., APlace), and an algorithm based on B*-tree methods in electronic VLSI.

### Lanes

Lanes are provided to allow waveguides to skip layers ("skip lane") and/or to allow waveguides to feed backwards ("return lane"), if the architecture is not purely feed-forward (e.g., FIG. 9). The routing of the waveguides in the lanes may follow the same principle as the routing in the architecture layers dedicated to routing described below.

### Routing

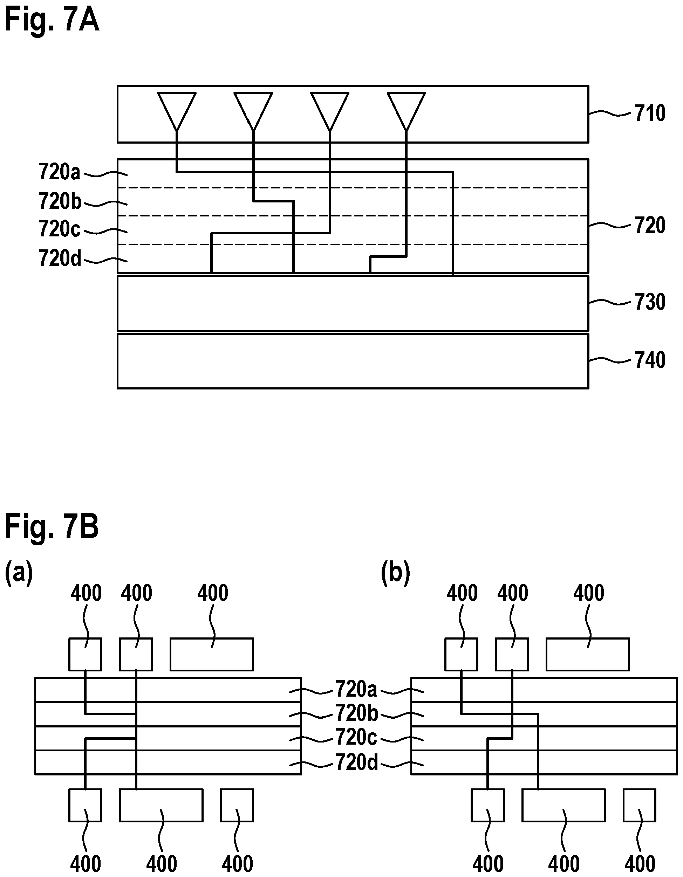

FIG. 7A shows an input 710 with pins, an architecture layer 720 dedicated to routing (corresponding to layer 110a in other Figures) and two architecture layers 730, 740 dedicated to standard cells (corresponding to layer 110b in other Figures). In other embodiments, layer 740 could be another architecture layer dedicated to routing.

The architecture layer 720 is divided into multiple sub-layers 720a-d, wherein one sublayer is provided per route. However, multiple horizontal routes per sub-layer can be allowed, if any vertical overlap is guaranteed to be avoided (although the routes may cross).

FIG. 7B (a) shows a situation in which inputs and outputs of the standard cells 400 are aligned and the routes overlap in sublayers 720b and 720c in a vertical direction. Such undesired vertical overlap can be avoided in the embodiments of the present disclosure by horizontally offsetting the inputs and outputs of the standard cells 400, as shown in FIG. 7B (b). The horizontal offset of the inputs and outputs of the standard cells 400 has the additional benefit that adverse effects of scattered light can be reduced.

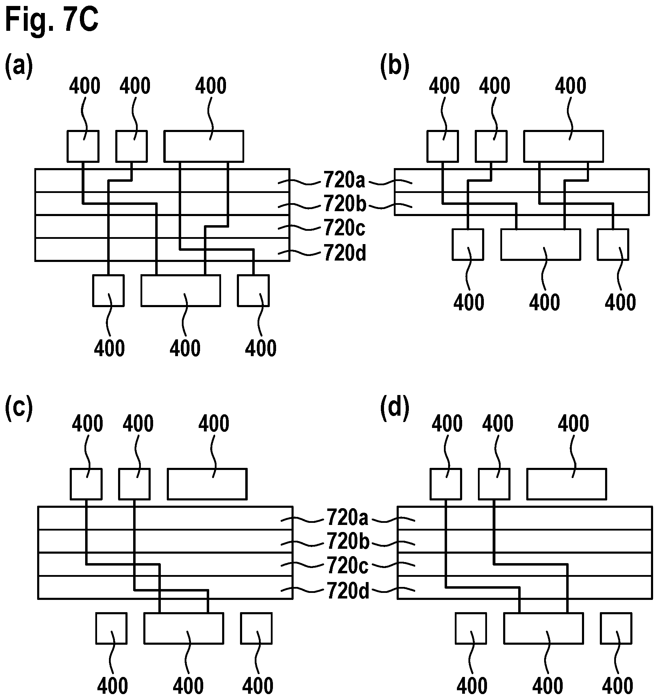

FIG. 7C shows routing examples according to non-limiting embodiments of the present disclosure.

In FIG. 7C (a), one sublayer per route is provided, and each sublayer includes only one horizontal route. FIG. 7C (b) shows an optimized version of FIG. 7C (a), in which multiple horizontal routes per sub-layer are provided, avoiding vertical overlaps, so that the number of sublayers can be reduced.

In FIG. 7C (c), the routes cross in sublayers 720c and 720d but do not overlap in a vertical direction. FIG. 7C (b) shows an optimized version of FIG. 7C (a) in which the routes do not cross without changing the lengths of the routes/waveguides ("Shuffling").

Exemplary algorithms suitable for configuring the architecture layers include, but are not limited to, an algorithm based on Manhattan routing with extra constraints (e.g., curves instead of 90° bends; the start and end points having a direction/angle and can only be connected if the waveguide has the same direction/angle), an A* search algorithm, and a Dijkstra's algorithm.

According to some embodiments, which can be combined with other embodiments described herein, the photonic circuit layout constructed as described above can be optimized by re-defining the plurality of architecture layers and/or the one or more lanes and/or the plurality of routes. Optimizing the generated photonic circuit layout can be performed based on minimizing optical power, minimizing a number of optical amplifiers, minimizing a maximal routing distance, maximizing an extinction ratio, and/or minimizing a floor space.

FIG. 8 shows a photonic circuit layout 800 according to embodiments described herein.

In the example of FIG. 8, a circuit input 810 and a circuit output 820 are arranged at opposite sides of the stack of the plurality of architecture layers 110. The architecture layers 110 are stacked in feed-forward direction, with multiple standard cell architecture layers 110b (and optionally one or more architecture layers 110a dedicated to routing) between an input routing architecture layer 110aa at the top and an output routing architecture layer 110ab at the bottom of the stack. In addition, two lanes 120a, 120b are provided. A first lane 120a of the two lanes is a skip line (feed-forward lane), and a second lane 120b of the two lanes is a return lane (feed-backward lane).

The present disclosure is not limited to the order of layers shown in FIG. 8. In further embodiments, the stack can include one or more additional architecture layers dedicated to routing (e.g., 110aa - 110b - 110a - 110b - 110a - 110b - 110ab).

FIG. 9 shows a photonic circuit layout 900 according to further embodiments described herein.

In the example of FIG. 9, a circuit input 910 and a circuit output 920 are arranged at the same side of the stack of the plurality of architecture layers 110.

The architecture layers 110 are divided into a first stack 112 and a second stack 114. The first stack 112 and the second stack 114 are arranged adjacent to each other with a lane 120b therebetween. Further lanes 120a, 120c are provided on each side of the first stack 112 and the second stack 114.

The first stack 112 may include a plurality of architecture layers 110aa, 110b between the circuit input 910 at the top and a cross-routing layer 930 at the bottom of the stack. An input routing architecture layer 110aa faces the circuit input 910, and multiple standard cell architecture layers 110b are arranged between the input routing architecture layer 110aa and the cross-routing layer 930.

The second stack 114 may include a plurality of architecture layers 110ab, 110b between the circuit output 920 at the top and the cross-routing layer 930 at the bottom of the stack. An output routing architecture layer 110ab faces the circuit output 920, and multiple standard cell architecture layers 110b are arranged between the output routing architecture layer 110ab and the cross-routing layer 930.

The present disclosure is not limited to the order of layers shown in FIG. 9. In further embodiments, the stacks can include one or more additional architecture layers dedicated to routing (e.g., 110aa - 110b - 110a - 110b and 110a - 110b - 110b - 110ab).

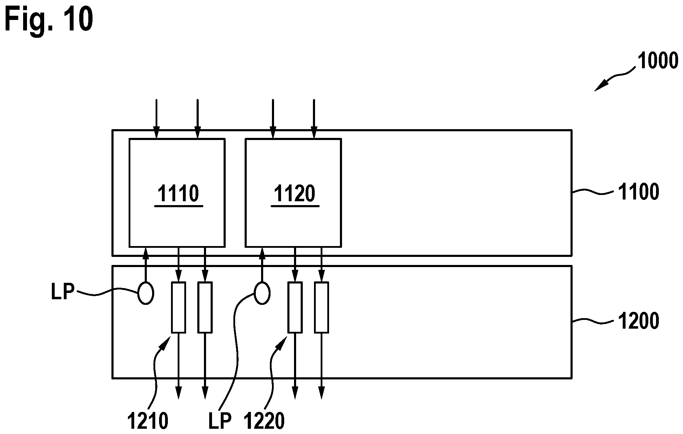

FIG. 10 shows a partial photonic circuit layout 1000 according to further embodiments described herein.

The photonic circuit layout 1000 includes a first standard cell architecture layer 1100 having standard cells 1110, 1120 and a second standard cell architecture layer 1200 having lasers (or grating couplers) 1210, 1220. Laser-pumping is indicated with reference numeral LP. The lasers 1210, 1220 face towards inputs to isolate the outputs as much as possible.

The methods described herein may be implemented in software, hardware, or a combination thereof, in different embodiments. In addition, the order of the blocks of the methods may be changed, and various elements may be added, reordered, combined, omitted, modified, etc. Various modifications and changes may be made as would be obvious to a person skilled in the art having the benefit of this disclosure. The various embodiments described herein are meant to be illustrative and not limiting. Many variations, modifications, additions, and improvements are possible. Accordingly, plural instances may be provided for components described herein as a single instance. Boundaries between various components, operations and data stores are somewhat arbitrary, and particular operations are illustrated in the context of specific illustrative configurations. Other allocations of functionality are envisioned and may fall within the scope of claims that follow. Finally, structures and functionality presented as discrete components in the example configurations may be implemented as a combined structure or component. These and other variations, modifications, additions, and improvements may fall within the scope of embodiments as defined in the claims that follow.

## Claims

1. A computer-implemented method for constructing a photonic circuit layout, comprising:
generating, using a standard cell representation defining a plurality of photonic standard cells, a photonic circuit layout by:
- defining a stack of a plurality of architecture layers, the plurality of architecture layers including at least one first architecture layer dedicated to routing and at least one second architecture layer dedicated to photonic standard cells;
- defining one or more lanes, each lane including at least one waveguide bypassing at least one architecture layer of the plurality of architecture layers; and
- defining a plurality of routes, each route defining a waveguide path within the at least one first architecture layer dedicated to routing.

2. A computer-implemented method of claim 1, wherein generating the photonic circuit layout further includes:
- arranging a circuit input and a circuit output at a same side of the stack of the plurality of architecture layers, or
- arranging a circuit input and a circuit output at opposite sides of the stack of the plurality of architecture layers.

3. A computer-implemented method of claim 1 or 2, wherein:
- the standard cell representation includes, or is, a photonic standard cell netlist; and/or
- the plurality of photonic standard cells are selected from the group consisting of data processing cells; memory cells; light-related cells, in particular optical amplification cells and/or laser cells; and delay cells.

4. A computer-implemented method of any one of claims 1 to 3, wherein the plurality of architecture layers are stacked in feed-forward.

5. A computer-implemented method of any one of claims 1 to 4, wherein a first architecture layer dedicated to routing is arranged between two second architecture layers dedicated to photonic standard cells to provide an interface between the two second architecture layers.

6. A computer-implemented method of any one of claims 1 to 5, wherein the one or more lanes include:
- at least one first lane, wherein the at least one first lane is a feed-forward lane; and/or
- at least one second lane, wherein the at least one second lane is a feed-backward lane.

7. A computer-implemented method of any one of claims 1 to 6, wherein at least two routes of the plurality of routes within the at least one first architecture layer dedicated to routing cross.

8. A computer-implemented method of any one of claims 1 to 7, wherein at least one route of the plurality of routes within the at least one first architecture layer dedicated to routing has a non-sharp bend.

9. A computer-implemented method of any one of claims 1 to 8, wherein the plurality of routes are arranged based on Manhattan routing, in particular wherein the at least one first architecture layer has a plurality of sub-layers, wherein the plurality of routes are arranged based on Manhattan routing in each sub-layer of the plurality of sub-layers.

10. A computer-implemented method of any one of claims 1 to 9, further including:
optimizing the generated photonic circuit layout by re-defining the plurality of architecture layers and/or the one or more lanes and/or the plurality of routes.

11. A computer-implemented method of claim 10, wherein optimizing the generated photonic circuit layout is performed based on one or more of the following:
- minimizing optical power;
- minimizing a number of optical amplifiers;
- minimizing a maximal routing distance;
- maximizing an extinction ratio;
- minimizing a floor space.

12. A computer program comprising instructions which, when the program is executed by a computer, cause the computer to carry out the method of any one of claims 1 to 11.

13. A computer-readable storage medium comprising instructions which, when the program is executed by a computer, cause the computer to carry out the method of any one of claims 1 to 11.

14. A data processing system for constructing a photonic circuit layout, comprising one or more processors configured to:
generate, using a standard cell representation defining a plurality of photonic standard cells, a photonic circuit layout by:
- defining a stack of a plurality of architecture layers, the plurality of architecture layers including at least one first architecture layer dedicated to routing and at least one second architecture layer dedicated to photonic standard cells;
- defining one or more lanes, each lane including at least one waveguide bypassing at least one architecture layer of the plurality of architecture layers; and
- defining a plurality of routes, each route defining a waveguide path within the at least one first architecture layer dedicated to routing.

15. A photonic circuit layout, comprising:
- a stack of a plurality of architecture layers, the plurality of architecture layers including at least one first architecture layer dedicated to routing and at least one second architecture layer dedicated to photonic standard cells;
- one or more lanes, each lane including at least one waveguide bypassing at least one architecture layer of the plurality of architecture layers; and
- a plurality of routes, each route defining a waveguide path within the at least one first architecture layer dedicated to routing.
